(19) Europäisches Patentamt

European Patent Office

Office européen des brevets

(11) Veröffentlichungsnummer : **0 069 877**
**B1**

(12) **EUROPÄISCHE PATENTSCHRIFT**

(45) Veröffentlichungstag der Patentschrift :
09.10.85

(21) Anmeldenummer : 82105363.4

(22) Anmeldetag : 18.06.82

(51) Int. Cl.⁴ : **H 03 K 17/97**

(54) Sensortaste zur kontaktlosen Erzeugnung eines elektrischen Signals bei Tastendruck.

(30) Priorität : 09.07.81 DE 3127053

(43) Veröffentlichungstag der Anmeldung :
19.01.83 Patentblatt 83/03

(45) Bekanntmachung des Hinweises auf die Patenterteilung : 09.10.85 Patentblatt 85/41

(84) Benannte Vertragsstaaten :
CH DE FR GB IT LI NL SE

(56) Entgegenhaltungen :
FR-A- 2 241 169
IEEE TRANSACTIONS ON MAGNETICS, Band MAG-15, Nr. 6, November 1979, Seiten 1806-1808, New York (USA); K. MOHRI et al.: "Sensitive force transducers using a single amorphous core multivibrator bridge"
SIEMENS FORSCHUNGS- UND ENTWICKLUNGS-BERICHTE, Band 10, Nr. 2, 1981, Seiten 83-90, Würzburg (DE); R. BOLL et al.: "Magnetic sensors of new materials"

(73) Patentinhaber : VACUUMSCHMELZE GMBH
Grüner Weg 37 Postfach 2253
D-6450 Hanau 1 (DE)

(72) Erfinder : Boll, Richard, Dr.
Kreuzstrasse 25
D-6052 Mühlheim (DE)
Erfinder : Friedrichs, Michael, Dipl.-Ing.
Kath.-Belgica-Strasse 3a
D-6450 Hanau 1 (DE)

## Beschreibung

Die Erfindung betrifft eine Sensortaste.

Aus der Zeitschrift IEEE Transactions on Magnetics, Vol. MAG-15, No. 6, Nov. 1979, S. 1806-1808, ist es bekannt, einen Ringbandkern aus amorphem weichmagnetischem Material mit Wicklungen zu versehen und an die Wicklungen Multivibratoren in Brückenschaltung anzuschließen. Der Ringbandkern wird von einer Wicklung mit hochfrequentem Wechselstrom magnetisiert, so daß in der zweiten Wicklung eine Wechselspannung induziert wird, die vom Verlauf der Hystereseschleife des Ringbandkerns aus amorphem Material abhängt. Bei Verformung des Ringbandkerns durch eine mechanische Kraft wird die Hystereseschleife flacher, so daß in der Sekundärwicklung des Ringbandkerns eine niedrigere Spannung induziert wird. Hierdurch wird der Multivibrator veranlaßt, seine Ausgangsspannung zu ändern, so daß die gesamte Anordnung einen Wandler darstellt, der eine mechanische Kraft bzw. einen Weg in ein elektrisches Signal umsetzt.

Aufgabe der vorliegenden Erfindung ist es, eine besonders vorteilhafte Anordnung zur Ausbildung einer Sensortaste unter Ausnutzung dieses bekannten Effektes der Umwandlung von mechanischer Kraft in ein elektrisches Signal zu schaffen.

Diese Aufgabe wird durch die im Kennzeichnenden Teil des Anspruchs 1 angegebenen Merkmale gelöst.

Ausführungsbeispiele sind schematisch in den Figuren 1 bis 3 dargestellt. Figur 4 zeigt die Hystereseschleife bei gedrücktem und nicht gedrücktem Tastaturknopf und in Figur 5 ist der dazugehörige Spannungsverlauf am Eingang des an die Wicklung 15 zu beiden Seiten des zugehörigen Ringbandkerns angeschlossenen Schwellwertverstärkers 11 dargestellt.

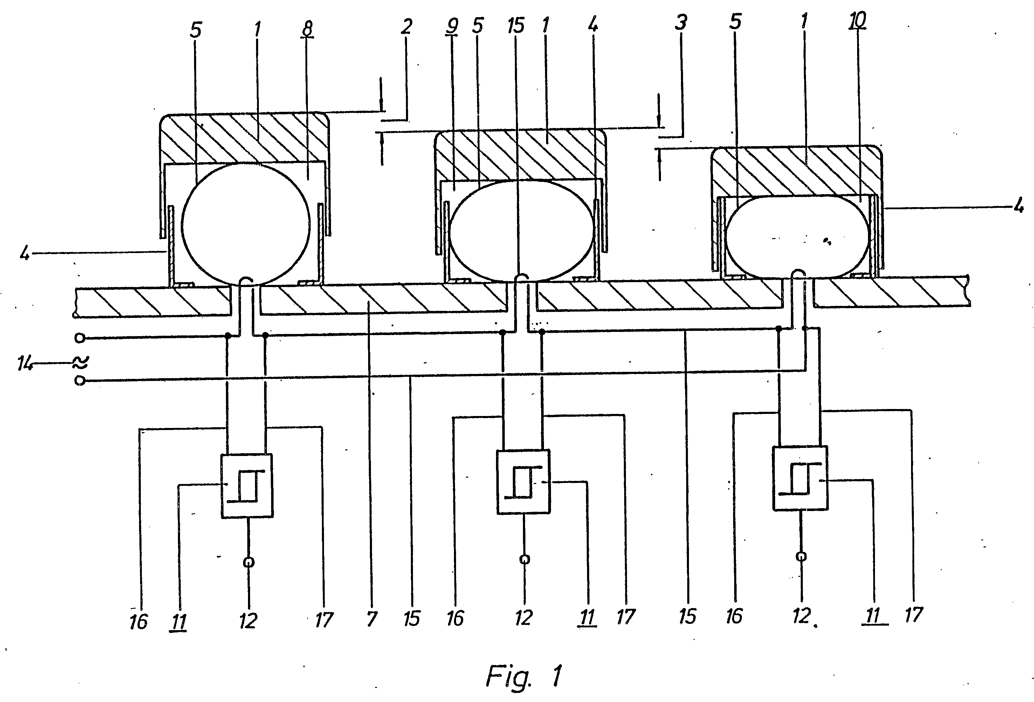

In Figur 1 sind auf einer Grundplatte 7 mehrere Gehäuse 4 aufgebracht, die jeweils durch einen aufgesteckten Tastaturknopf 1 oben abgeschlossen sind. Im Inneren jedes Gehäuses 4 befindet sich je ein Ringbandkern 5 aus einem weichmagnetischen amorphen Material, das zusätzlich zu guten weichmagnetischen Eigenschaften ein gutes Federverhalten besitzt. Beispielsweise können die Ringbandkerne 5 aus folgenden aus einer Schmelze abgeschreckten Metallegierungen bestehen :

$Co_{75}Si_{15}B_{10}$
$Co_{60}Ni_{17}Si_{14}B_9$
$Ni_{40}Fe_{40}Mo_2Si_{10}B_8$
$Fe_{70}Co_{10}B_{20}$

In Figur 1 sind drei Sensortasten 8, 9, 10 dargestellt, deren Tastaturknöpfe 1 verschieden weit niedergedrückt sind. Der Tastaturknopf 1 der Sensortaste 8 ist dabei nicht gedrückt, während der Tastaturknopf 1 der Sensortaste 9 bereits einen Tastenhub entsprechend dem Abstand 2 zurückgelegt hat. Man sieht, daß das Gehäuse 4 so dimensioniert ist, daß beim Herunterdrücken des Tastaturknopfes 1 um den Abstand 2 sich der Ringbandkern 5 zu beiden Seiten an die Wände des Gehäuses 4 anlegt. Bei weiterem Herunterdrücken des Tastaturknopfes 1 um einen zusätzlichen Abstand 3 — wie es bei der Sensortaste 10 gezeigt ist — verformt sich der Ringbandkern 5 mit kleineren Krümmungsradien, so daß der Widerstand des Ringbandkerns 5 gegen ein Herunterdrücken des Tastaturknopfes 1 von der bei der Sensortaste 2 gezeigten Position in der bei der Sensortaste 3 gezeigten Position sprunghaft erhöht wird. Hierdurch erhält die Sensortaste nach der Erfindung also einen Druckpunkt, ohne daß hierzu ein zusätzliches Bauelement notwendig wäre.

Die Sensortasten 8 bis 10 in Figur 1 können Teil einer Tastatur sein und sind an eine gemeinsame Wicklung 15 angeschlossen, die von einer hochfrequenten Wechselspannungsquelle 14 mit Wechselstrom versorgt wird. An die Wicklung 15 sind vor und hinter jedem Ringbandkern die Eingangsanschlüsse 16 und 17 je eines Schwellwertverstärkers 11 angeschlossen. Die Schwellwertverstärker 11 sind dabei so eingestellt, daß entweder während des Tastenhubs entsprechend Abstand 3 an dem Ausgang 12 des Schwellwertverstärkers 11 eine Spannungsänderung auftritt, die für eine daran angeschlossene elektrische Schaltung das Signal darstellt, ob die jeweilige Sensortaste gedrückt ist oder nicht.

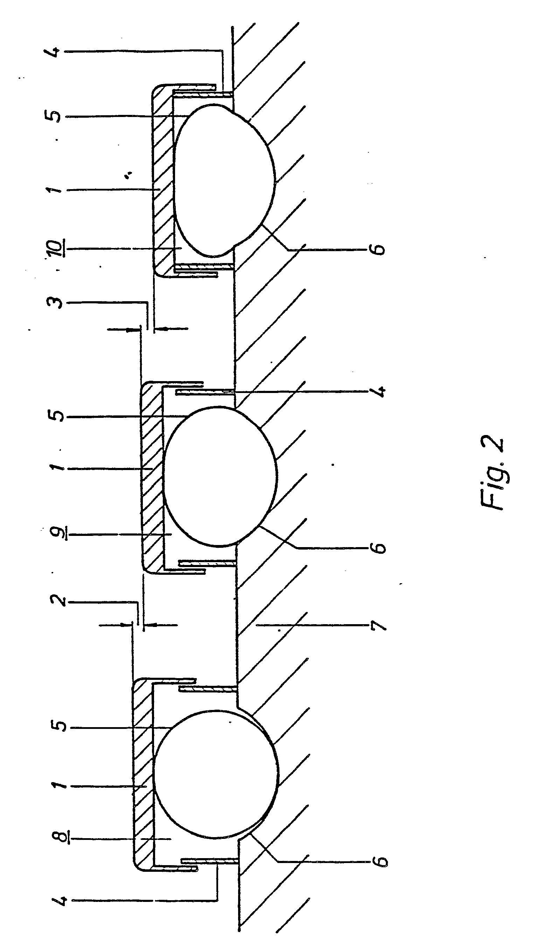

Figur 2 zeigt eine andere Möglichkeit, um den Ringbandkern 5 sowohl als magnetischen Kern, als Feder und als Bauteil zur Erzielung eines Druckpunktes einzusetzen. In Figur 2 sind wiederum die Sensortasten 8, 9, 10 dargestellt. Die Ringbandkerne 5 liegen in je einer Mulde 6, deren Krümmungsradius größer ist als der Krümmungsradius des Ringbandkerns 5, wenn dieser nicht verformt ist. Nachdem der Tastaturknopf 1 um den Abstand 2 heruntergedrückt ist, (Sensortaste 9) legt sich die untere Hälfte des Ringbandkerns 5 an die Mulde 6 an, so daß wiederum ein Druckpunkteffekt entsteht, wenn der Tastaturknopf in den Abstand 3 weiter heruntergedrückt wird.

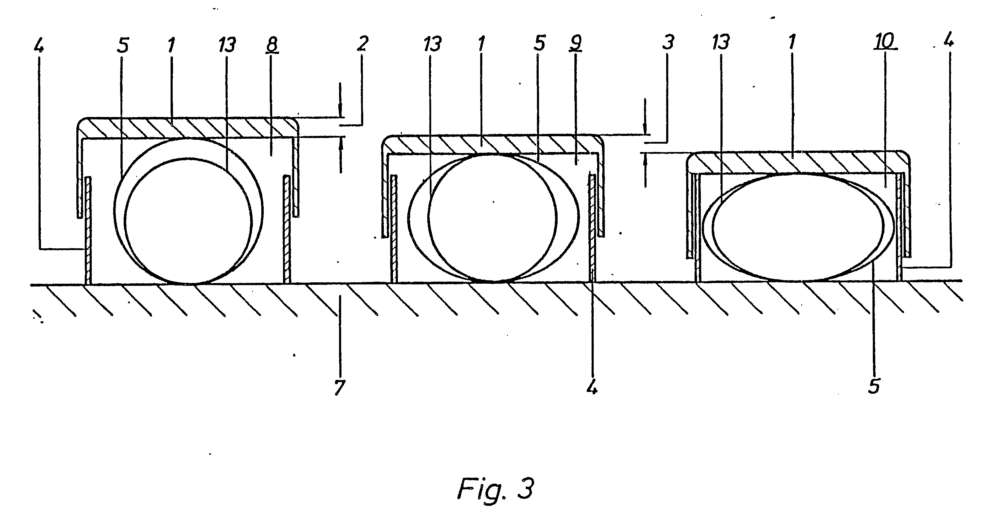

In Figur 3 sind wiederum die Sensortasten 8, 9 und 10 in unterschiedlichen Stellungen dargestellt ; dieses Ausführungsbeispiel unterscheidet sich von den übrigen dadurch, daß jeweils zwei Ringbandkerne 5 und 13 mit unterschiedlichem Durchmesser vorgesehen sind. Diese Ringbandkerne können an einer Stelle miteinander verbunden sein, es ist auch möglich, sie aus einem einzigen Band aus amorphem material zu wickeln. Wie aus Figur 3 zu ersehen ist, verformt sich zunächst nur der äußere Ringbandkern 5, bis dieser sich an den inneren Ringbandkern 13 anlegt. Von diesem Weitpunkt an werden beide Ringe 5 und 13 verformt, so daß eine andere Druckkraft zum Drücken der Tasten erforderlich ist.

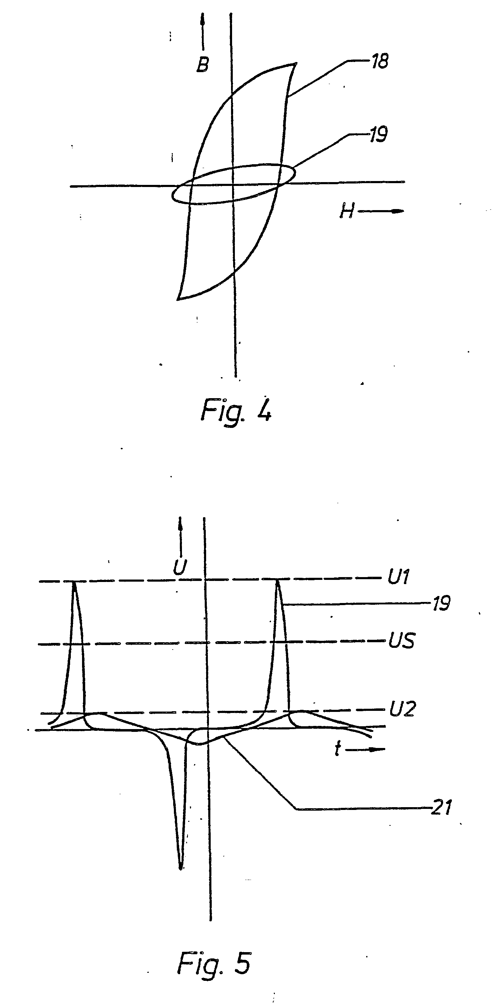

Figur 4 zeigt die Hystereseschleife 18 bei nicht verformtem Ringbandkern 5 und die Hystereseschleife 20 des verwendeten amorphen Materials, die sich einstellt, wenn der Tastaturknopf 1 heruntergedrückt ist. In beiden Fällen ist bei einer bestimmten Wechselstrommagnetisierung die Induktion B über die Feldstärke H aufgetragen.

Das Diagramm nach Figur 5 zeigt über der Zeit t den Verlauf des Spannungsabfalls U, wie er an den Eingangsanschlüssen 16 und 17 eines Schwellwertverstärkers 11 bei nicht gedrücktem Tastaturknopf 1 — entsprechend Kurve 19 — und bei gedrücktem Tastaturknopf 1 — entsprechend Kurve 21 — auftritt. Die maximale Spannung bei nicht gedrücktem Tastaturknopf 1 ist durch die gestrichelte Linie $U_1$ und bei gedrücktem Tastaturknopf durch die gestrichelte Linie $U_2$ in Figur 5 gekennzeichnet. Hierbei lassen sich die Schwellwertverstärker 11 so einstellen, daß sie beispielsweise bei einer Spannung entsprechend der gestrichelten Linien $U_s$ schalten.

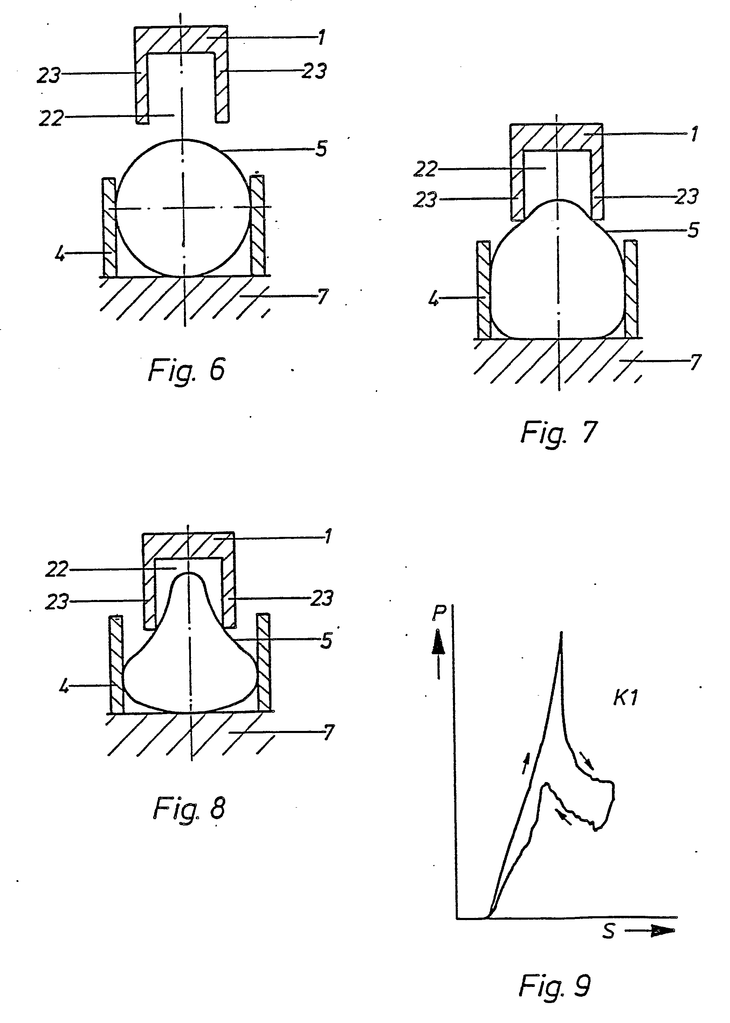

Anhand der Figuren 6 bis 13 werden zwei weitere Ausführungsbeispiele für die Konstruktion einer Tastatur erläutert, bei denen beim Niederdrücken des Tastaturknopfes 1 längs eines Weges S die von dem Ringbandkern 5 ausgeübte Federkraft P zunächst ansteigt und dann bei weiterem Niederdrücken wieder zu geringeren Werten abfällt. Hierdurch wird ein Druckpunkt erzeugt, der den Bediener der Tastatur nach Überschreiten des Maximalbereichs der Kraft P zwingt, die Taste bis zum Anschlag weiter durchzudrücken.

Ein derartiges Druckpunktverhalten läßt sich mit der Anordnung nach den Figuren 6, 7 und 8 erzielen. Hier befindet sich auf der Grundplatte 7 wiederum ein Gehäuse 4, das die seitliche Ausdehnung des Ringbandkerns 5 verhindert. Der Tastaturknopf 1 besitzt auf der dem Ringbandkern 5 zugewandten Seite eine nutenförmige Öffnung 22, die durch zwei Ränder 23 seitlich begrenzt wird.

Der Querschnitt der nutenförmigen Öffnung ist im Ausführungsbeispiel rechteckig dargestellt, er kann jedoch beliebig gestaltet sein und muß nur die Bedingung erfüllen, daß der Ringbandkern in die nutenförmige Öffnung hineinrutschen kann.

Figur 7 zeigt die Anordnung nach Figur 6, nachdem der Tastaturknopf 1 soweit hinuntergedrückt ist, daß die Ränder 23 den Ringbandkern berühren. Hier beginnt bereits die Verformung des Ringbandkerns 5.

Figur 8 zeigt die Anordnung nachdem der Ringbandkern 13 in die nutenförmige Öffnung 22 hineingerutscht ist.

In Figur 9 ist eine in einer Versuchsanordnung nach Figuren 6 bis 8 gemessene Kurve K1 dargestellt, die über dem Weg S des Tastaturknopfes 1 beim Niederdrücken und beim Loslassen die vom Ringbandkern 5 auf den Tastaturknopf 1 einwirkende Kraft darstellt. Sobald die Ränder 23 den Ringbandkern 5 berühren, steigt die vom Ringbandkern 5 ausgeübte Kraft steil an. Wegen der Reibung zwischen den Rändern 23 und Ringbandkern 5 wird dabei der unterhalb des Tastaturknopfes 1 befindliche Teil des Ringbandkerns 5 stärker verformt als der Teil, der sich zwischen den Rändern 23 befindet. Bei weiterem Niederdrücken und bei sich steigernder Krafteinwirkung zwischen Ringbandkern 5 und Tastaturknopf 1 wird an einer Stelle des Weges S die Haftreibung zwischen den Rändern 23 und dem Ringbandkern 5 überwunden und wegen des gegenüber der Haftreibung verringerten Wertes der Gleitreibung rutscht der obere Teil des Ringbandkerns 5 in die nutenförmige Öffnung 22 hinein. Dies bedingt einen steilen Abfall der vom Ringbandkern 5 auf den Tastaturknopf 1 ausgeübten Kraft, wie aus der Kurve K1 ersichtlich ist. Die Kräfte beim Loslassen des Tastaturknopfes sind durchgehend geringer als beim Niederdrücken, da die Reibung jetzt versucht, den Tastaturknopf 1 in der gedrückten Stellung festzuhalten. Ansonsten ergibt sich im Prinzip ein ähnlicher Kraftverlauf wie beim Niederdrücken des Tastaturknopfes 1, d. h., beim Loslassen steigt die Kraft zunächst von einem unteren Wert wieder an und fällt dann nach Überschreiten des Maximums, das beim Hinausrutschen des Ringbandkerns aus der nutenförmigen Öffnung 22 erreicht wird, wiederum steil ab.

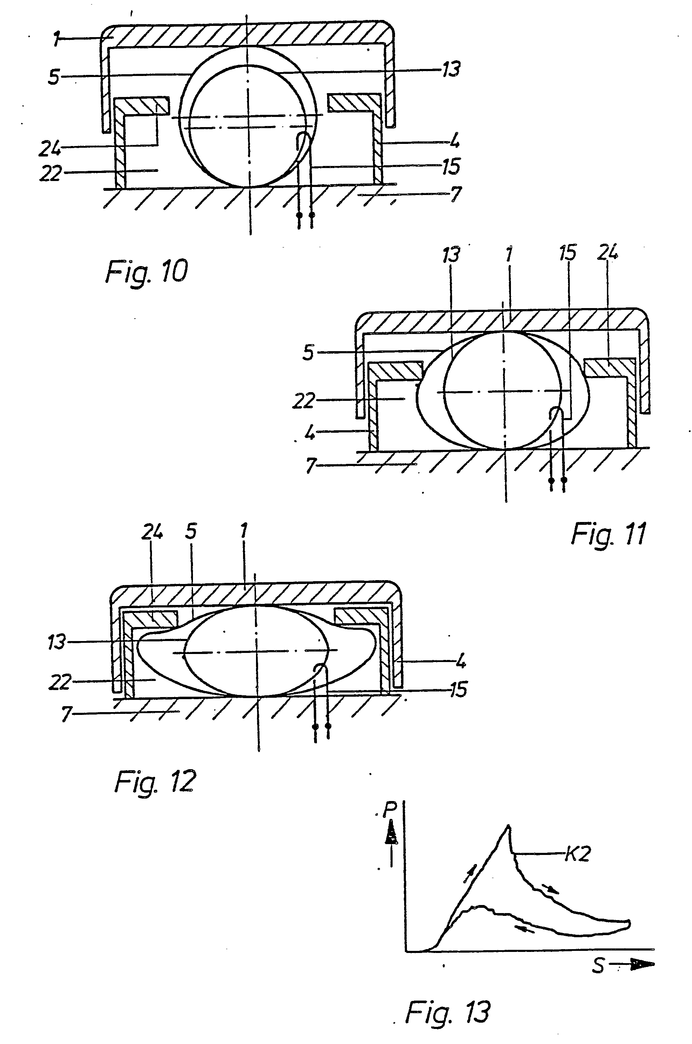

Eine ähnliche Anordnung mit ebenfalls abfallender Federkraft nach Überschreiten des Maximums zeigen die Figuren 10 bis 12, wiederum bei entsprechenden Stellungen des Tastaturknopfes 1. Hier besitzt die Wand des Gehäuses 4 oberhalb des Mittelpunktes des Ringbandkerns 5 einen sich nach innen zum Ringbandkern hin erstreckenden Vorsprung 24, der zusammen mit der Wand des Gehäuses 4 und der Grundplatte 7 eine zum Ringbandkern 5 hin offene, nutenförmige Öffnung 22 bildet. Wiederum wird der Unterschied zwischen Haft- und Gleitreibung zwischen Ringbandkern und Vorsprung 24 ausgenutzt, um nach einem Anstieg der Kraft, entsprechend Kurve K2 in Figur 13, einen Abfall der Federkraft zu erzielen.

Sowohl beim Ausführungsbeispiel nach den Figuren 6 bis 8 als auch beim Ausführungsbeispiel nach den Figuren 10 bis 12 ist die Breite der nutenförmigen Öffnung 22 maßgeblich für den Kurvenverlauf. Falls diese Breite zu groß ist, kann sich der Ringbandkern in der Öffnung festklemmen, so daß die Reibungskraft gegenüber der Federkraft überwiegt und eine negative Kraft zum Hochziehen der Tastatur erforderlich ist. Falls die Breite der Öffnung zu klein ist, sind unter Umständen zu hohe Kräfte bzw. zu große Verformungen des Ringbandkerns notwendig, wenn der maximale Wert des Kraftanstiegs überschritten werden soll. Für jede Konstruktion sind daher die einzelnen Werte vorher experimentell zu ermitteln.

Bei der beschriebenen Tastatur wird also die Verformung des Ringbandkerns sowohl ausgenutzt, um eine Federkraft auf den Tastaturknopf zu erzeugen, als auch dazu, um ein elektrisches Signal aus den bei Verformung sich verändernden magnetischen Eigenschaften zu ermitteln. Dabei steht die Form der Hystereseschleife des Materials nicht in direkter Abhängigkeit zu der Federkraft, wie sie in den Figuren 9 und 13 gemessen wurde. Trotzdem kann der Wunsch bestehen, daß sowohl eine Federkraftkennlinie nach den Figuren 9 oder 13, als auch eine kontinuierliche Verformung des Ringbandkerns mit dem Weg des Tastaturknopfes erreicht werden soll. Hierzu ist es möglich, wie in den Figuren 10 bis 12 dargestellt, wiederum einen zweiten Ringbandkern 13 mit gegenüber dem Ringbandkern 5 kleinerem Durchmesser vorzusehen und diesen mit einer Wicklung 15 zu umwickeln. Bei einer derartigen Anordnung lassen sich sowohl die Federkennlinie als auch die magnetische Kennlinie über den Weg S des Tastaturknopfes unabhängig voneinander einstellen.

## Patentansprüche

1. Sensortaste dadurch gekennzeichnet, daß ein mit mindestens einer elektrischen Wicklung versehene Ringbandkern aus einer amorphen, welchmagnetischen Metallegierung verwendet wird, wobei die durch Verformung des Ringbandkerns hervorgerafene Änderung seiner Hystereseschleife zu einer Spannungsänderung in der Wicklang fährt, die ein ausnutzbares, elektrisches Signal darstellt, und daß ein Anschlag (Gehäuse 4, Mulde 6) vorgesehen ist, der so in der Nähe des Ringbandkerns (5) angeordnet ist, daß dieser sich bei seiner Verformung an den Anschlag anlegt, so daß zur weiteren Verformung eine sprunghafte Änderung der Druckkraft erforderlich ist.

2. Sensortaste nach Anspruch 1, dadurch gekennzeichnet, daß sich der Ringbandkern (5) in einem Gehäuse (4) befindet, daß das Gehäuse (4) von einem Tastaturknopf (1) abgeschlossen ist, der an dem Ringbandkern (5) anliegt und daß der Ringbandkern (5) so dimensioniert ist, daß er sich beim Niederdrücken des Tastaturknopfes (1) seitlich an die Wände des Gehäuses anlegt.

3. Sensortaste nach Anspruch 1, dadurch gekennzeichnet, daß der Ringbandkern (5) in einem Gehäuse (4) angeordnet ist, daß das Gehäuse (4) einen Tastaturknopf (1) trägt, der an dem Ringbandkern (5) anliegt und daß der Ringbandkern (5) auf der dem Tastaturknopf (1) gegenüberliegenden Seite in eine Mulde (6) hineinragt, deren Radius größer ist als der Außenradius des Ringbandkerns.

4. Sensortaste nach Anspruch 1, dadurch gekennzeichnet, daß in dem Ringbandkern (5) ein weiterer Ringbandkern (13) mit kleinerem Durchmesser angeordnet ist, daß der Ringbandkern (5) an einem Tastaturknopf (1) anliegt, so daß bei Herunterdrücken des Tastaturknopfes (1) nach einem Tastenhub (2) sich der Ringbandkern (5) beidseitig an den Ringbandkern (13) mit kleinerem Durchmesser anlegt und daß bei weiterem Herunterdrücken des Tastaturknopfes bis zu einem Tastenhub (3) sich beide Ringbandkerne (5 und 13) zusammen verformen.

5. Tastatur bestehend aus Sensortaste nach Anspruch 1, dadurch gekennzeichnet, daß mehrere Ringbandkerne (5) eine gemeinsame, an eine hochfrequente Wechselspannungsquelle (14) angeschlossene Wicklung (15) besitzen und daß die Eingangsanschlüsse (16, 17) je eines Schwellwertverstärkers (11) für jeden Ringbandkern (5) an diese Wicklung zu beiden Seiten des zugehörigen Ringbandkerns (5) angeschlossen sind.

6. Sensortaste nach Anspruch 1, dadurch gekennzeichnet, daß der Tastaturknopf (1) eine nutenförmige Öffnung (22) besitzt, deren Ränder (23) bei Niederdrücken des Tastaturknopfes (1) mit dem Ringbandkern (5) in Berührung kommen, daß die Ränder (23) voneinander weniger entfernt sind, als der Durchmesser des Ringbandkerns (5) beträgt, und daß die nutenförmige Öffnung so groß bemessen ist, daß der sich verformende Ringbandkern in die nutenförmige Öffnung hineinrutschen und sich darin frei ausbreiten kann.

7. Sensortaste nach Anspruch 6, dadurch gekennzeichnet, daß der Ringbandkern (5) in einem zum Tastaturknopf (1) hin offenen Gehäuse untergebracht ist und sich bei Verformung an die Gehäusewände anlegt.

8. Sensortaste nach Anspruch 1, dadurch gekennzeichnet, daß mindestens eine Gehäusewand des Gehäuses (4) einen nach innen zum Ringbandkern (5) hin ragenden Vorsprung (24) besitzt, an den sich bei Verformung der Ringbandkern (5) anlegt und daß der Vorsprung (24) von der Grundplatte (7) so weit entfernt ist, daß sich zwischen Vorsprung (24) und Grundplatte (7) eine zum Ringbandkern (5) hin offene nutenförmige Öffnung (22) bildet.

9. Sensortaste nach Anspruch 6, dadurch gekennzeichnet, daß der Abstand der Ränder (23) der nutenförmigen Öffnung (22) in dem Tastaturknopf (1) und damit die Breite der nutenförmigen Öffnung (22) etwa halb so groß ist wie der Durchmesser des Ringbandkerns (5).

10. Sensortaste nach Anspruch 8, dadurch gekennzeichnet, daß der Abstand zwischen dem nach innen ragenden Vorsprung (24) in der Gehäusewand (4) und der Grundplatte (7) etwas größer ist als der halbe Durchmesser des Ringbandkerns (5).

11. Sensortaste nach Anspruch 6 bis 10, dadurch gekennzeichnet, daß sich im Innern des Ringbandkerns (5) ein zweiter Ringbandkern (13) mit kleinerem Durchmesser befindet und daß die Wicklung (15) nur den inneren Ringbandkern (13) umschließt.

## Claims

1. A sensor key, characterised in that an annular strip core is used, made of an amorphous soft-magnetic metal alloy and provided with at least one electrical winding, wherein the change in its hysteresis loop caused by deformation of the annular strip core, leads to a change of voltage in the winding, which represents a usable electrical signal ; and that a stop (housing 4, hollow 6) is provided, which is arranged in the vicinity of the annular strip core (5) in such manner that the latter abuts against the stop during its deformation, so that a sudden change in the pressing force is required for further deformation.

2. A sensor key as claimed in Claim 1, characterised in that the annular strip core (5) is arranged in a housing (4); that the housing (4) is closed by a push button (1) which abuts against the annular strip core (5); and that the annular strip core (5) is so dimensioned that, on depression of the push button (1), it laterally abuts against the walls of the housing.

3. A sensor key as claimed in Claim 1, characterised in that the annular strip core (5) is arranged in a housing (4); that the housing (4) carries a push button (1) which abuts against the annular strip core (5); and that on the side opposite the push button (1), the annular strip core (5) protrudes into a bowl-shaped hollow (6), the radius of which is larger than the outer radius of the annular strip core.

4. A sensor key as claimed in Claim 1, characterised in that a further annular strip core (13) having a smaller diameter is arranged in the annular strip core (5); that the annular strip core (5) abuts against a push button (1) so that when the push button (1) is depressed, after a key travel (2), the annular strip core (5) abuts against both sides of the annular strip core (13) having the smaller diameter, and that when the push button is further depressed through a key travel (3), both annular strip cores (5 and 13) are deformed together.

5. A keyboard comprising sensor keys as claimed in Claim 1, characterised in that a plurality of annular strip cores (5) have a common winding (15) which is connected to a high-frequency alternating voltage source (14); and that the input terminals (16, 17) of a respective threshold value amplifier (11) for each annular strip core (5) are connected to this winding on either side of the annular strip core (5) allotted thereto.

6. A sensor key as claimed in Claim 1, characterised in that the push button (1) has a groove-shaped opening (22), the edges (23) of which come into contact with the annular strip core (5) when the push button (1) is depressed; that the edges (23) are spaced from one another by an amount which is less than the diameter of the annular strip core (5); and that the groove-shaped opening has dimensions such that the deforming annular strip core can slide into the groove-shaped opening and freely expand therein.

7. A sensor key as claimed in Claim 6, characterised in that the annular strip core (5) is accommodated in a housing which is open towards the push button (1) and abuts against the walls of the housing during deformation.

8. A sensor key as claimed in Claim 1, characterised in that at least one wall of the housing (4) has a projection (24) which protrudes inwardly towards the annular strip core (5) and against which the annular strip core (5) abuts during deformation; and that the projection (24) is spaced away from the base plate (7) to an extent such that a groove-shaped opening (22) which is open towards the annular strip core (5) is formed between the projection (24) and the base plate (7).

9. A sensor key as claimed in Claim 6, characterised in that the distance between the edges (23) of the groove-shaped opening (22) in the push button (1), and thus the width of the groove-shaped opening (22), is approximately half the diameter of the annular strip core (5).

10. A sensor key as claimed in Claim 8, characterised in that the distance between the inwardly protruding projection (24) in the wall of the housing (4) and the base plate (7) is somewhat greater than half the diameter of the annular strip core (5).

11. A sensor key as claimed in Claim 6 to 10, characterised in that inside the annular strip core (5), a second annular strip core (13) which has a smaller diameter is arranged; and that the winding (15) only surrounds the inner annular strip core (13).

**Revendications**

1. Capteur à touche, caractérisé en ce qu'on utilise un noyau en bande en forme d'anneau en un alliage de métaux à aimantation douce, amorphes, que l'on munit d'au moins un enroulement électrique, la variation de sa boucle d'hystérésis engendrée par la déformation du noyau en bande en forme d'anneau aboutissant à une variation de tension dans l'enroulement, qui donne un signal électrique utilisable et en ce qu'une butée (boîtier 4, rainure 6) est prévue au voisinage du noyau en bande en forme d'anneau (5) de façon que celui-ci s'applique contre cette butée au cours de sa déformation pour rendre nécessaire une modification brusque de la force de compression pour sa déformation ultérieure.

2. Capteur à touche selon la revendication 1, caractérisé en ce que le noyau en bande en forme d'anneau (5) est logé dans un boîtier (4), en ce que le boîtier (4) est fermé par une touche (1) qui s'appuie contre le noyau en bande en anneau (5) et en ce que le noyau en bande en forme d'anneau (5) est dimensionné pour qu'à l'enfoncement de la touche (1), il s'applique latéralement contre les parois du boîtier.

3. Capteur à touche selon la revendication 1, caractérisé en ce que le noyau à bande en forme d'anneau (5) est prévu dans un boîtier (4), en ce que le boîtier (4) porte une touche (1) qui s'appuie contre le noyau en bande en forme d'anneau (5) et en ce que le noyau en bande en forme d'anneau (5) pénètre, du côté opposé à la touche (1) dans une rainure (6) dont le rayon est supérieur au rayon extérieur du noyau en bande en forme d'anneau.

4. Capteur à touche selon la revendication 1, caractérisé en ce qu'un autre noyau à bande en forme d'anneau (13) de plus petit diamètre est prévu dans le noyau en bande en forme d'anneau (5), en ce que le noyau en bande en forme d'anneau (5) s'appuie contre une touche (1) de façon qu'à l'enfoncement de la touche (1), après une course de touche (2), le noyau en bande en forme d'anneau (5) s'appuie des deux côtés contre le noyau en bande en forme d'anneau (13) de plus petit diamètre et en ce qu'au cours de la suite de l'enfoncement de la touche jusque pour une course de touche (3), les deux noyaux en bande en forme d'anneau (5 et 13) se déforment simultanément.

5. Clavier composé de capteurs à touche selon la revendication 1, caractérisé en ce que plusieurs noyaux en bande en forme d'anneau (5) ont un enroulement (15), commun branché sur une même source de tension alternative haute fréquence (14), et en ce que les bornes (16, 17) d'un amplificateur à seuil (11) respectif pour chaque noyau en bande en forme d'anneau (5) sont reliées à cet enroulement, des deux côtés du noyau en bande en forme d'anneau (5) correspondant.

6. Capteur à touche selon la revendication 1, caractérisé en ce que la touche (1) présente une ouverture (22) en forme de rainure dont les bords (23) arrivent en contact avec le noyau en bande en forme d'anneau (5) lors de l'enfoncement de la touche (1), en ce que l'écartement des bords (23) est inférieur au diamètre du noyau en bande en forme d'anneau (5) et en ce que l'ouverture en forme de rainure est suffisamment grande pour que le noyau en bande en forme d'anneau qui se déforme puisse glisser dans l'ouverture en forme de rainure et puisse s'y étaler librement.

7. Capteur à touche selon la revendication 6, caractérisé en ce que le noyau en bande en forme d'anneau (5) est logé dans un boîtier ouvert en direction de la touche (1) et s'appuie contre les parois du boîtier lors de la déformation.

8. Capteur à touche selon la revendication 1, caractérisé en ce qu'au moins une paroi du boîtier (8) comporte une partie en saillie (24) dirigée vers l'intérieur vers le noyau en bande en forme d'anneau (5), partie en saillie contre laquelle s'appuie le noyau en bande en forme d'anneau (5) lors de sa déformation et en ce que la partie en saillie (24) est suffisamment éloignée de la plaque de base (7) pour former entre la partie en saillie (24) et la plaque de base (7), une ouverture (22) en forme de rainure ouverte en direction du noyau en bande en forme d'anneau (5).

9. Capteur à touche selon la revendication 6, caractérisé en ce que la distance entre les bornes (23) de l'ouverture (22) en forme de rainure de la touche (1) et ainsi la largeur de l'ouverture (22) en forme de rainure est sensiblement moitié du diamètre du noyau à bande en forme d'anneau (5).

10. Capteur selon la revendication 8, caractérisé en ce que la distance entre la partie en saillie (24) dirigée vers l'intérieur de la paroi (4) et la plaque de base (7) est sensiblement supérieure au demi-diamètre du noyau en bande en forme d'anneau (5).

11. Capteur à touche selon les revendications 6 à 10, caractérisé en ce qu'un second noyau en bande en forme d'anneau (13) de plus petit diamètre est prévu à l'intérieur du noyau en bande en forme d'anneau (5) et en ce que l'enroulement (15) entoure le noyau en bande en forme d'anneau, intérieur (13).

Fig. 1

Fig. 2

0 069 877

Fig. 3

*Fig. 4*

*Fig. 5*

Fig. 6

Fig. 7

Fig. 8

Fig. 9

Fig. 10

Fig. 11

Fig. 12

Fig. 13